# DEMANDE DE BREVET EUROPEEN

(11) **EP 3 333 778 A1**
(43) Date de publication de la demande: **13.06.2018**
(21) Numéro de dépôt: 16306653.3
(22) Date de dépôt: 09.12.2016
(51) Int. Cl.: G06K 19/077, G06K 19/073

(54) **ASSEMBLAGE SECURISE DE DOCUMENT OU DE SUPPORT**

(71) Demandeur: Gemalto SA, 92190 Meudon (FR)
(72) Inventeur: GASPARI, Sébastien, 13881 Gemenos Cedex (FR); ALLEYSSON, Blandine, 13881 Gemenos Cedex (FR); BOUSQUET, Christophe, 13881 Gemenos Cedex (FR)

(57) **Abrégé**

L'invention concerne un procédé de fabrication d'un document de sécurité (1) dans lequel on réalise un corps (8,11) comportant deux couches superposées (12, 15), un circuit (13) électrique et/ou à puce électronique (3) noyé entre les couches, un premier adhésif (4) adhérant aux couches et/ou au circuit ;
Le procédé se caractérise en ce que le procédé comprend une étape de dépôt d'un second adhésif (5) différent ou présentant un comportement différent du premier aux solvants ou à la température et adhérant en partie à au moins l'une des couches (12, 15) et/ou au circuit (2).

## Description

### Domaine de l'invention

L'invention concerne des documents ou des supports de sécurité et leur procédé de fabrication.

L'invention concerne plus particulièrement un document de sécurité comprenant un élément sécuritaire sous forme de circuit électronique et un autre élément sous forme graphique porté par un substrat, l'ensemble étant intimement lié mécaniquement et/ou physiquement. La liaison est telle qu'une séparation frauduleuse d'un élément de l'ensemble engendre une détérioration de l'un et/ou l'autre et dissuade un fraudeur de l'utiliser ultérieurement en l'associant à un autre élément sécuritaire frauduleux.

Elle concerne notamment des solutions où une antenne est intimement liée à une couche de recouvrement d'un document à puce supportant ou pas une photographie du porteur.

Les documents de sécurité sont associés à des applications sécurisées. Ils constituent notamment des passeports, des cartes d'identité, des permis de conduire, des cartes d'accès, des cartes de santé, des cartes téléphoniques prépayées ou des cartes bancaires par exemple. De tels documents sont largement utilisés et comprennent en général un module à puce électronique ou une puce électronique nue formant ou reliant un circuit.

Lorsqu'ils comprennent un module électronique, ils peuvent fonctionner avec et/ou sans contact selon l'application à laquelle ils sont destinés. Ils peuvent se présenter notamment sous forme de carte, ou de livret par exemple. De tels documents de sécurité sont personnalisés graphiquement et/ou électriquement avec notamment des informations personnelles ou spécifiques à une entité ou personne (clé de chiffrement...) .

Les informations personnelles sont les données du porteur du document, telles que par exemple sa photo, son nom, sa date de naissance, son numéro de sécurité sociale, une information biométrique telle qu'une empreinte par exemple, une date de validité, etc.... Ces informations personnelles sont imprimées sur la surface du document ou dans un ou plusieurs feuillets du document lorsqu'il se présente sous forme de livret. Ces informations sont en général également stockées dans une puce du module électronique pour comparaison. Du fait de la valeur importante associée à ces informations personnelles, ces documents de sécurité sont souvent la cible de malfaiteurs qui les copient, les modifient ou les contrefont.

Des inlays courants (ou inserts électroniques) pour passeport électronique et/ou une couche de recouvrement électronique de passeport utilisent un adhésif pour sceller ensemble deux couches de matériau plastique et/ou papier, entre lesquelles se trouve un transpondeur de communication radiofréquence (RFID). Une fraude consiste à retirer le circuit électronique du document de sécurité notamment par délamination des feuilles qui le prennent en sandwich, à l'aide d'un solvant ou de la chaleur à température élevée. Dans la mesure où ces adhésifs sont souvent sensibles à la chaleur et/ou un solvant, il est donc possible de démonter la structure de l'inlay par une délamination des feuilles du support par le biais de la température et/ou un solvant pour accéder au transpondeur sans l'endommager. Par conséquent, ce transpondeur radiofréquence peut être réinséré dans un faux passeport qui généralement peut avoir des données graphiques manipulées.

L'objectif de l'invention est de faire en sorte que si l'attaque ci-dessus est effectuée, le transpondeur et/ou le document manipulé présente une preuve évidente de fraude notamment en étant visiblement dégradé ou non fonctionnel sur le plan électronique, évitant ainsi qu'il soit réinséré dans un faux support ou document.

L'invention vise d'une manière générale à proposer une solution pour prévenir des actes délictueux sur des documents de sécurité.

L'invention concerne plus particulièrement, mais de manière non limitative, des cartes ou livrets de type passeports qui trouvent notamment leurs applications dans le contrôle d'identité, le contrôle d'accès, la santé, et/ou la banque. Le support peut aussi être de tout type comportant des couches ou feuilles superposées, tel qu'un tissu, un objet, meuble, accessoire vestimentaire, bracelet, tout objet obtenu en impression 3D.

### Art antérieur

Le brevet EP 1 646 972 B1 décrit des moyens d'appairage d'une antenne radiofréquence à un module de carte à puce de type contact et sans contact (hybride). Des propriétés électriques de l'antenne sont stockées dans la puce du module, l'antenne étant intimement liée à une couche supportant une photographie du titulaire. La puce fonctionne uniquement si des propriétés électriques stockées dans la puce concordent avec celles mesurées lors de l'utilisation.

### Problème technique

L'invention a donc pour but de remédier à au moins un des inconvénients de l'art antérieur. En particulier, l'invention vise à proposer un procédé de fabrication d'un document ou support de sécurité doté de moyens évitant la fraude ci-dessus. De préférence, le procédé de fabrication doit être aisé à mettre en oeuvre et économique.

### Résumé de l'invention

Cette invention consiste préférentiellement à appliquer au moins deux différents types de colle / adhésif présentant des points de fusion et/ou des sensibilités aux solvants différents pour assembler au moins deux couches de matériau enfermant un circuit électronique / électrique. Un transpondeur radiofréquence ou circuit électrique / électronique est inséré entre ces deux couches de matériau.

De préférence, au moins une de ces deux couches couvre partiellement le transpondeur ou circuit afin que toute tentative de démontage de l'ensemble ainsi constitué provoque une rupture du circuit ou l'endommagement d'une couche de matériau et/ou graphique notamment dans les zones (point, ligne, surface) limitrophes où une couche de colle de plus faible pouvoir adhésif se termine (du fait notamment d'une action frauduleuse de désactivation d'un adhésif d'assemblage).

De préférence, la seconde couche de colle a une surface réduite par rapport à la première. Elle peut être appliquée par différents moyens d'enduction (type Dr Roller), buse de colle, enduction, par exemple, mais liste non limitative.

A cet effet, l'invention a pour objet un procédé de fabrication d'un document de sécurité dans lequel on réalise un corps comportant deux couches superposées, un circuit électrique et/ou à puce électronique noyé entre les couches, un premier adhésif adhérant aux couches et/ou au circuit ; Le procédé est caractérisé en ce qu'il comprend une étape de dépôt d'un second adhésif différent ou présentant un comportement différent du premier aux solvants ou à la température et adhérant en partie à au moins l'une des couches et/ou au circuit.

Ainsi, l'invention permet de surprendre un fraudeur lors d'une tentative de démontage du document et de provoquer une détérioration visible du document (puisque le fraudeur pense à priori au recours d'un seul adhésif pour la fabrication du document).

Selon d'autres caractéristiques optionnelles du document de sécurité :
- Les premier et second adhésifs diffèrent par leur température de fusion et/ ou leur sensibilité aux solvants ; De préférence, l'écart de température de fusion et/ou de sensibilité est assez important pour bien surprendre le fraudeur. Lesdites températures de fusion peuvent différer de 20 à 50 °C et/ou leur différence de degré de sensibilité aux solvants va au moins du simple au double ou à la limite, il n'existe pas de solvant commun aux deux adhésifs ;
- A la limite, l'écart de sensibilité à un solvant peut être très important entre eux, par exemple de préférence supérieur à deux. Exprimée en écart absolu, la différence de durée nécessaire à la dissolution des adhésifs respectifs par un même solvant peut être de préférence supérieure à 5 minutes.

Exprimé de manière relative, un même solvant peut requérir de préférence au moins deux fois plus de temps pour dissoudre ou désactiver un premier adhésif (ou au moins deux fois plus de quantité) que pour le second adhésif ; La différence relative de durée peut être plus importante d'un facteur 5 ou 10 ou 100.
Par exemple, dans le cas de l'utilisation de deux colles polyuréthane, l'une première réactive et l'autre non, la première est dissoute par l'acétone après plus de 10 heures alors que la seconde ne nécessite que quelques minutes.
- Les adhésifs 4, 5 peuvent être disposés à l'interface séparant les couches dans des zones (Z1, Z2) complémentaires ou séparés ou adjacents sur leur bord mince;
- Les adhésifs 4 et 5 peuvent présenter un recouvrement partiel de leur zone respective (ils peuvent se chevaucher l'un étant ou reposant sur l'autre);
- Le second adhésif est de plus grande résistance à la température et/ou à au moins un solvant et se trouve disposé dans des zones (Z2) sensibles situées en regard du module et/ou en regard d'au moins une connexion de l'antenne au module ; En effet, des endroits limitrophes des zones complémentaires ou qui se chevauchent au moins partiellement constituent des endroits singuliers de fragilisation qui sont particulièrement exposés lors d'un démontage car ils permettent de générer des détériorations plus facilement ; La connexion peut s'effectuer notamment par tout moyen connu, tel que soudure, brasure, colle conductrice, interpénétration ; Ainsi, lors d'une séparation, les zones sensibles résistent mieux au démontage et facilitent une rupture d'un des éléments constituant l'ensemble ;

- Le second adhésif est de plus grande résistance à la température et/ou à au moins un solvant et se trouve disposé dans des zones (Z2) sensibles situées en regard du module et/ou en regard d'au moins une connexion de l'antenne au module ;
- Le second adhésif est de plus grande résistance à la température et/ou à un solvant que le premier adhésif et se trouve disposé dans une zone centrale (Z2), le premier adhésif étant placé autour du second adhésif ou le bordant sur au moins deux côtés,
- Au moins une des deux couches d'adhésif couvre partiellement le circuit transpondeur afin que toute attaque entraîne une rupture du circuit transpondeur, au croisement du circuit transpondeur et des deux couches de colle ;
- Au moins un des adhésifs est disposé de manière à présenter dans une direction quelconque à l'interface entre lesdites couches de matériau, au moins une alternance d'adhésifs différents ou ayant des comportements d'adhérence différents selon la température et/ou les solvants ;
- Au moins un des adhésifs est disposé de manière aléatoire et/ou sous forme de cordon en spirale ou en zigzag ou présente un bord formé de segments de droite brisée ou en forme de denture;
- Les colles peuvent être identiques à l'origine mais appliquées ou activées différemment. Par exemple, une colle à base thermoplastique ayant une phase thermodurcissable peut être activée différemment selon des endroits prédéterminés. L'activation peut être thermique ou par rayonnement (UV, IR...) ou par distribution d'activateur ou de catalyseur (par exemple sur des couches discontinues de colles notamment époxy). L'activation peut être aléatoire ou choisie et différente d'un « inlay » à un autre pour augmenter la difficulté de démontage d'un lot de documents ou de supports de sécurité.

L'invention a également pour objet un document de sécurité obtenu par le procédé ci-dessus et se présente sous forme de carte ou de livret.

### Brève description des figures

D'autres particularités et avantages de l'invention apparaitront à la lecture de la description suivante faite à titre d'exemple illustratif et non limitatif, en référence aux Figures annexées qui représentent :
- La figure 1 illustre un document de sécurité en cours de fabrication selon un premier mode du procédé de fabrication de l'invention ;
- La figure 2 illustre une vue en coupe d'un document (ou insert) de sécurité pouvant être obtenu sensiblement selon le procédé de la figure 1 ;
- La figure 3 illustre une carte sans-contact réalisée selon un second mode de mise en oeuvre du procédé ;
- La figure 4 illustre l'objet de la figure 3 selon la coupe A-A ;
- La figure 5 illustre l'objet de la figure 4 agrandi avec des zones remarquables Z1-Z2 dans la structure du document de sécurité ;
- La figure 6 illustre schématiquement un comportement de la structure du document de sécurité au cours d'une opération frauduleuse de séparation des feuilles 12 et 15 de recouvrement du circuit électrique et/ou électronique.

### Description

Par document de sécurité, on entend tout document notamment sous forme de carte ou de livret, portant des informations personnelles d'une personne ou entité. Ils trouvent des applications notamment, mais non exclusivement, dans les passeports, les cartes d'identité, les permis de conduire, les cartes d'accès, les cartes de santé, les cartes téléphoniques prépayées ou les cartes bancaires par exemple.

Les documents de sécurité peuvent comprendre ou non une antenne de communication radiofréquence 2. Les exemples décrits ci-dessous font référence à des documents comprenant une telle antenne 2. L'invention ne se limite cependant pas à ces cas et s'applique également à des documents de sécurité ne comprenant pas d'antenne. Le transpondeur (2, 3) peut être remplacé par un circuit 13 (non représenté) électrique et/ou électronique (par exemple avec capteur d'empreinte, capacité, résistance, contact électrique ou d'interconnexion, plaque capacitive filaire ou non...)

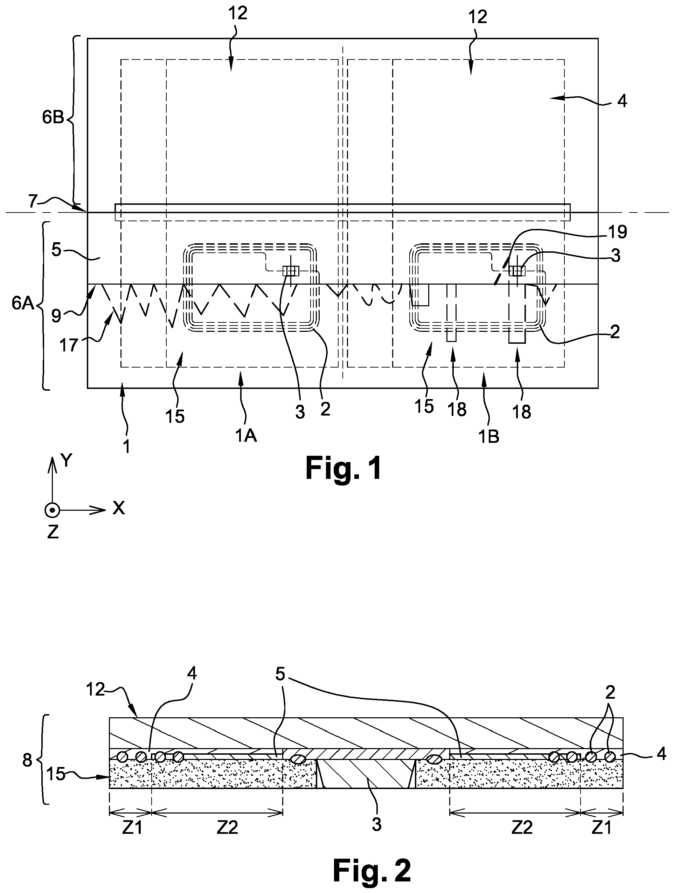

Sur les figures 1 et 2 est illustré un document de sécurité 1 en cours de fabrication selon un premier mode du procédé de fabrication de l'invention. Le procédé réalise un corps 8 d' «inlay» (ou d'insert) comportant deux couches de matériau superposées, un circuit électrique 13 et/ou à puce électronique 3 noyé entre les couches, un premier adhésif 4 adhérant aux couches et/ou au circuit.

Dans l'exemple (fig. 2), le corps 8 comprend une feuille ou couche 12 de couverture de passeport (présenté en lot de deux). La couche 12 peut être réalisée dans un matériau plastique, tel que par exemple du PVC (Polychlorure de vinyle), du PLA (acide poly lactique), du PC (polycarbonate), du PET ou PETG (Polyéthylène téréphtalate ou polyéthylène téréphtalate glycolisé), dans un papier ou dans un matériau synthétique commercialisé sous la marque « Teslin », ou tout autre papier dit « synthétique »,ou textile.

Cette couche 12 est destinée à être laminée et/ou collée à au moins une autre couche de constitution 15 . L'assemblage de la couche 12 avec au moins une couche 15 de constitution (ou de recouvrement) permet de former (après découpe au niveau des pointillés) un document de sécurité au format d'une carte ou d'un livret (dans le cas d'un passeport par exemple). Dans le cas du livret, l'assemblage des couches comprenant l'antenne 2 peut former un feuillet interne ou une couverture d'un livret notamment de passeport.

Ici dans l'exemple, la couche 15, sous forme de feuille, est destinée à recevoir une autre couche 12 sous forme de couche de recouvrement par-dessus pour prendre le circuit transpondeur radiofréquence 2, 3 en sandwich. Une feuille support principale 1 est ici disposée longitudinalement en deux sous-parties 6A et 6B séparées par une charnière médiane 7 d'articulation.

Une antenne radiofréquence 2 (par lot de deux) est réalisée directement sur une face de cette feuille support principale notamment par incrustation de fil conducteur. Cette antenne 2 est sous forme de bobine plate et fonctionne à la fréquence de 13,56 MHZ. Elle pourrait avoir une autre forme (notamment dipolaire) et fonctionner à une autre fréquence notamment selon la technologie UHF.

L'antenne 2 est connectée à un module radiofréquence 3 détaillé ultérieurement en relation avec la figure 2.

Sur la feuille support principale 15 et dans sa partie supérieure 6B, on prévoit de déposer un premier adhésif 4 destiné à adhérer aux couches et/ou au circuit électrique et/ou électronique 2, 3. Le premier adhésif recouvre toute ou partie de la surface de la feuille 12.

Ce premier adhésif 4 est d'un premier type choisi parmi ceux connus de l'état de l'art par l'homme du métier incluant du polyuréthane réactif ou pas, un adhésif sensible à la pression (PSA), (thermofusible : hotmelt en anglais), une colle acrylique, une colle vinylique, une colle époxy....

L'adhésif 4 a une température de fusion ici comprise entre 100 et 120 °C et/ou sensible à un solvant par exemple l'eau et/ou présente une faible force d'adhérence aux couches 12 et 15, par exemple 20 à 30 N/cm².

Selon une caractéristique d'un mode préféré de l'invention, le procédé comprend une étape de dépôt d'un second adhésif 5 entre les couches 12 et 15). Dans l'exemple figure 1, ce second adhésif 5 est différent du premier et est conformé et appliqué de manière à adhérer à une zone partielle de la feuille 15 (ou couche) et au circuit. L'adhésif 5 a ici une forme de bande rectangulaire d'une largeur de l'ordre du 2/5 ième de la largeur de la couche ou sous-partie de feuille support 6A. La bande est disposée avec un bord longitudinal adjacent à ou aligné sur l'axe médian 7 de la feuille support principale 1 sur la sous-partie 6A. L'autre bord 9 de la bande d'adhésif 5 est parallèle à l'axe 7 et s'étend en partie sur le circuit 13.

L'adhésif est disposé ou placé en partie sur la sous-partie 12 ou 6A de feuille support 1 et sur le circuit (antenne 2) et module à puce 3, lequel est quant à lui réalisé au préalable dans l'exemple. Alternativement, le circuit peut être réalisé en partie sur l'adhésif 5 disposé au préalable sur la sous-partie 15, 6A de feuille support 1.

Ensuite, les deux sous-parties 6A, 6B (ou volets) sont repliées l'une contre l'autre autour de l'axe 7 et laminées ensemble de manière connue pour être assemblées durablement. Le cas échéant, les adhésifs peuvent être activés avant pliage et pressage de lamination par exemple, par température, rayonnement UV, IR...

Selon une caractéristique de ce mode préféré, les premier et second adhésifs peuvent différer par leur température de fusion et/ ou sensibilité aux solvants.

Ainsi par exemple, les premiers et seconds adhésifs diffèrent par une température de fusion comprise entre 20 à 50 °C. Alternativement ou de préférence cumulativement, ces adhésifs peuvent également ne pas avoir de solvant commun pour mieux prévenir un démontage malveillant.

Dans un cas d'une application juxtaposée d'adhésif EVA (éthylène-acétate de vinyle) et polyuréthane réactif, un solvant aqueux ne dissoudra que l'EVA, laissant intact l'adhésif polyuréthane. De même, l'utilisation d'une colle à réticulation UV et d'une colle à base solvant en application juxtaposée ou superposée, réagiront à des solvants différents.

Selon une caractéristique, les adhésifs sont disposés à l'interface séparant les couches ou feuilles et présentent un recouvrement partiel. A la figure 1, la zone de recouvrement des deux adhésifs 4 et 5 se situe adjacente à l'axe 7 et s'étend en largeur sur une distance correspondant à la largeur de l'adhésif 5.

Alternativement, les adhésifs peuvent être disposés dans des zones complémentaires qui ne se chevauchent pas après superposition des couches 12 et 15. Le dépôt peut être effectué précisément notamment par sérigraphie ou impression par jet de matière. Il peut y avoir un espace entre les adhésifs qui ne se chevauchent pas pour accentuer une transition lors d'une séparation des couches ou feuilles 12 et 15.

Alternativement, les lignes d'interface entre les première et seconde couches 12, 15 comprennent selon une direction quelconque dans un plan du document, une succession d'adhésifs différents ou des adhésions différentes selon des zones prédéterminées ou aléatoires ; Par exemple, la structure de feuille peut comprendre une ou plusieurs zone(s) exempte(s) d'adhésif (par exemple, l'adhésion pouvant être effectuée grâce à la nature même de la couche (polyuréthane, un thermo adhésif, un polycarbonate...). La structure peut comprendre une zone d'adhésion faible des couches entres elles suivie d'une zone de forte d'adhésion au niveau d'endroits quelconques du circuit.

Dans ces deux modes, les adhésifs sont préférentiellement agencés de manière que le parcours d'antenne et/ou zones de connexion du module à l'antenne subisse(nt) une transition d'adhésifs le long de leur parcours ou étendue, parallèlement au plan principal du document ou carte. Ainsi, l'antenne sur son parcours peut parcourir un environnement d'un premier adhésif puis subir une transition d'environnement pour passer à un environnement du second adhésif.

Alternativement, une première connexion du module à l'antenne peut être noyée par un adhésif tandis qu'une seconde connexion est noyée dans un autre adhésif différent du premier.

D'une manière générale, plutôt qu'être différents par nature, les adhésifs doivent surtout se comporter différemment l'un de l'autre selon la manière dont ils ont été appliqués ou conditionnés, ou activés.

Lorsqu'un fraudeur tente de ramollir l'adhésif 4, il peut décoller la feuille 12 avec l'adhésif de la sous-partie 15 ou 6A et uniquement la partie inférieure de l'antenne noyée dans l'adhésif 4 et en dehors de l'adhésif 5. Lorsque la force de séparation parvient au niveau de l'interface entre les deux adhésifs, l'antenne est retenue par le second adhésif sur le support 12. Si la force de séparation des feuilles est supérieure par exemple à environ deux newtons, l'antenne se rompt au niveau de la limite 9 ou interface 16 entre les deux adhésifs 4 et 5.

Alternativement, l'antenne peut parcourir, sur son parcours, un environnement d'un premier et second adhésifs en regard de l'antenne (par exemple placé d'un même côté de l'antenne) puis subir une transition d'environnement pour passer à un environnement constitué uniquement par un second adhésif assurant l'adhésion des deux sous-parties.

Selon une caractéristique, l'adhésif de plus grande résistance à la température et/ou à au moins un solvant est disposé à une interface séparant les couches dans des zones sensibles remarquables notamment situées en regard du module et/ou une connexion de l'antenne au module.

Ainsi, lors d'une séparation des couches initiée au niveau d'un premier adhésif de faible résistance ou pouvoir d'adhésion, l'adhésion demeure plus forte au niveau du second adhésif de plus forte résistance ou pouvoir d'adhésion. Toute traction poursuivie pour séparer les feuilles 12 et 15 conduit nécessairement à rompre le circuit.

Ainsi, cette absence d'adhésion relative augmente la vitesse de séparation des couches localement avant de résister fortement et facilite la rupture du circuit ou déchirement d'une des deux couches.

Par exemple, le premier adhésif nécessitera une force de séparation de 3 à 6 N/cm² alors que le second adhésif nécessitera une force de séparation de 20 à 30 N/cm², ce qui conduira à la diminution de la vitesse de séparation des couches et à une casse du fil d'antenne.

Selon une caractéristique, l'adhésif de plus grande résistance à la température et/ou à un solvant est disposé à l'interface des couches dans une zone centrale ; L'adhésif de plus faible résistance à la température et/ou à un solvant est placé autour du premier adhésif ou borde le premier adhésif sur au moins deux côtés.

Par exemple, un complexe composé d'une colle UV en zone centrale et d'une colle à base solvant de part et d'autre de cette zone centrale, réagira de manière différente sur les deux zones d'application face à une attaque solvant.

Selon une caractéristique, au moins une de ces deux couches couvrira partiellement le transpondeur afin que toute attaque entraîne une rupture du transpondeur au croisement du circuit avec les deux couches de colle.

Selon une autre alternative générale, illustrée également sur la figure 1 (en pointillés), les différents modes de réalisation du procédé se caractérisent en ce qu'au moins un des adhésif 12, 15 est disposé de manière à ce que la structure du document (ou carte) présente dans une direction quelconque, à l'interface entre lesdites couches de matériau, au moins une alternance d'adhésifs différents (dont la fonction est d'assembler les couches entre elles) ou ayant des comportements d'adhérence différents selon la température et/ou les solvants. L'alternance d'adhésifs suit de préférence une ligne brisée 17 irrégulière plutôt qu'une ligne droite 9 de manière à ce qu'un pirate / fraudeur ne puisse anticiper leur endroit de séparation.

Ainsi, par exemple dans une direction X parallèle au bord 9 dans le plan X, Y du repère XYZ, parallèle au plan principal du document X, Y, il se trouve une alternance de deux adhésifs 4 et 5 (notamment au niveau des dents d'adhésif 18) qui se comporteront différemment à des efforts de séparation du fait de dissolution et/ou fusion différentes.

Avantageusement, au moins un des adhésifs 4, 5 est disposé de manière aléatoire et/ou sous forme de cordon en spirale ou en zigzag ou présente un bord formé de segments de droite brisée ou en forme de denture 17, 18. Par exemple, l'invention prévoit de déposer un cordon de second adhésif sur un support par une distribution d'une buse qui oscille transversalement par rapport à une direction de défilement du support.

Alternativement, on peut déposer un film adhésif 4 ou 5 sur le support 12 ou 15 et on retire ou élimine par tout moyen connu (laser, prédécoupe, découpe..), une frange ou portion aléatoire du film. On peut aussi déposer les adhésifs par pulvérisation ou impression à l'aide d'un masque qui définit une forme prédéterminée ou aléatoire.

A la figure 2, un corps de carte ou d'inlay de passeport peut être obtenu sensiblement comme expliqué en référence à la figure 1. Il diffère cependant en ce que l'adhésif 5 est sensiblement centré sur le module ou puce 3. L'adhésif 5 chevauche (ou s'étend sur) une partie du circuit électrique radiofréquence notamment les spires 2 et adhère à la couche ou feuille 15. Un module électronique est placé dans une cavité de la feuille 15 et connecté à des extrémités d'antenne 2.

L'adhésif 4, différent de 5, recouvre presque tout le circuit électrique. Il chevauche l'adhésif 5, une partie des spires 2 déjà couvert par l'adhésif 5 et une partie des spires non couverte par l'adhésif 5.

Lors d'une tentative de séparation des feuilles 12 et 15, le circuit peut plus facilement se rompre au niveau de l'interface entre Z1 et Z2, correspondant à une transition (ou différence) d'adhérence des spires vis-à-vis des feuilles 12 et 15.

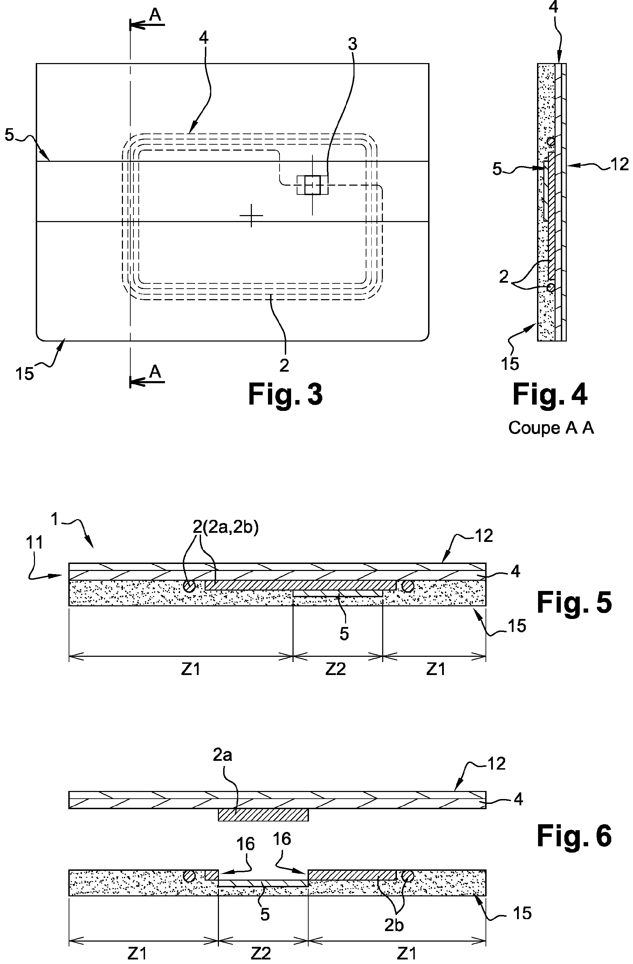

Les figures 3 à 4 illustrent une carte sans contact réalisée selon un second mode de mise en oeuvre du procédé. La carte comprend une feuille support 15 en « Teslin » ou feuille plastique et une feuille plastique 12 de couche de recouvrement, les deux couches de colle 4 et 5 ainsi que le transpondeur comprenant un module 3 à puce relié à l'antenne 2

La colle 5 a une étendue ou surface réduite et est d'abord appliquée sur la feuille support 1 dans une zone Z2, puis l'antenne 2 est incrustée ou déposée sur la feuille 15 dans une zone Z1 et en partie dans la zone Z2 sur la couche de colle 5 comprenant, par exemple une portion des petits côtés latéraux de l'antenne.

Ensuite, une couche de colle 4 est déposée de préférence sur la feuille support 15 par-dessus la colle 5 et une partie du transpondeur 2, 3 ;
Enfin, l'autre couche de recouvrement 12 est placée sur l'ensemble ci-dessus pour le recouvrir totalement. L'ensemble constitué de la feuille support inférieure 15, de la colle de surface réduite 5, du transpondeur 2,3, de la colle 4 et de la feuille 12 superposés dans cet ordre est laminé à chaud par exemple.

Le cas échéant, l'antenne peut être faiblement incrustée dans la feuille support 15 dans la mesure où cette dernière comporte un revêtement thermo adhésif pour fixer l'antenne. Par contre, l'antenne peut être plus fortement incrustée dans la couche de colle 5 à surface réduite.

A la figure 5 est illustré l'objet de la figure 4 avec une indication des zones remarquables Z1 et Z2 dans la structure du document de sécurité;
A la figure 6 est illustrée une séparation des feuilles support 12 et 15 et la fracture de l'antenne 2 en deux parties 2a et 2b aux interfaces des adhésifs 4 et 5

Par exemple, comme l'adhésif 4 est plus fort que l'adhésif 5, une partie 2a de l'antenne 2 (dans la zone Z2), adhère plus à la feuille 12 via l'adhésif 4, qu'elle n'adhère à la feuille 15 via l'adhésif 5.En conséquence, lors d'une séparation des feuilles 12 et 15, la partie 2a se rompt à l'interface de la zone Z1 avec Z2. Une partie 2a est entrainée par la feuille 12 tandis que l'autre partie 2b reste fixée à la feuille 15.

Le cas échéant, on effectue une lamination après incrustation du fil d'antenne sur le support 1 et sur la couche de colle réduite 5. La lamination est de préférence limitée sur la zone couverte par la colle 5.

Cela a pour effet d'enfoncer les spires ou pistes d'antenne dans la feuille support 15 et de bien les faire adhérer à cette feuille support au niveau de la zone de l'adhésif 5. Au contraire, les spires ou pistes d'antenne situées en dehors de la couche de colle 5, sont moins enfoncées dans la feuille support 1 et ou l'adhésif 5 du fait de l'épaisseur de l'adhésif 5.

En cas d'élévation de la température de l'ensemble par un fraudeur, la colle 4 se ramollit en premier, il est possible d'effectuer un décollement de la feuille 12 par rapport à la feuille 15 en emportant une partie de l'antenne qui adhère toujours à la colle 4.

Par contre, la colle 5 n'a pas encore atteint sa température de fusion et maintient une adhésion sur l'autre feuille 15 et sur une partie complémentaire de l'antenne du transpondeur. En cas de poursuite d'une force de séparation des feuilles 12, 15, il se produit donc une rupture à l'interface (ligne 9 ou 17) séparant les zones où s'étendent les deux adhésifs car une partie de l'antenne est tirée par la feuille 12 et l'autre partie de l'antenne est retenue par la feuille 15 et l'adhésif 5.

Lorsque l'antenne 2 est réalisée par incrustation d'un fil métallique dans la première couche 15, on utilise de préférence une sonotrode qui, lorsqu'elle est soumise à des ondes ultrasonores, restitue l'énergie vibratoire résultante dans le fil à incruster.

Une autre étape du procédé de fabrication du document peut consister en outre à ménager une cavité 14 d'accueil dans la couche 12 afin d'y insérer un module électronique 13 et de le connecter électriquement à l'antenne 2. La réalisation de cette cavité peut être réalisée avant ou après la réalisation de l'antenne. La connexion du module électronique 3 aux extrémités du fil d'antenne est ensuite réalisée par un procédé de thermo compression connu de l'homme du métier.

Sur tous les modes de réalisation, la forme de l'étendue des adhésifs notamment l'adhésif de surface réduite peut être quelconque ou aléatoire comme à la figure 1. En particulier l'adhésif 4 peut présenter au moins un côté formé de lignes brisées ou de dents 17, 18 (illustrées en pointillés) ou en zigzag ou en étoiles à la place de la limite inférieure 9 rectiligne de manière à éviter une prévision de la limite de l'un des adhésifs vu de l'extérieur. Par exemple, l'adhésif 4 peut avoir des projections ou langues 18 irrégulières s'étendant en direction du circuit.

Alternativement, l'adhésif 5 peut avoir une zone 19 libre d'adhésion ou d'adhésif et s'étendant sur une partie du circuit pour provoquer des disparités dans l'adhésion et compliquer la tâche d'un fraudeur.

L'adhésif 5 peut avoir une résistance à la température supérieure à 120 °C et/ou peut être soluble uniquement à un solvant (ex. l'acétone) et/ou présente une forte adhésion aux substrats (couche de recouvrement en Teslin™ ou papier).

## Revendications

1. Procédé de fabrication d'un document de sécurité (1) dans lequel on réalise un corps (8,11) comportant deux couches superposées (12, 15), un circuit (13) électrique et/ou à puce électronique (3) noyé entre les couches, un premier adhésif (4) adhérant aux couches et/ou au circuit,
**caractérisé en ce que** le procédé comprend une étape de dépôt d'un second adhésif (5) différent ou présentant un comportement différent du premier aux solvants ou à la température et adhérant en partie à au moins l'une des couches (12, 15) et/ou au circuit (13).

2. Procédé selon la revendication 1, **caractérisé en ce que** les premier (4) et second adhésifs (5) diffèrent par leur température de fusion et/ ou leur sensibilité aux solvants.

3. Procédé selon la revendication 2, **caractérisé en ce que** lesdites températures de fusion diffèrent de 20 à 50 °C et/ou que leur différence de degré de sensibilité aux solvants va au moins du simple au double ou qu'il n'existe pas de solvant commun aux deux adhésifs.

4. Procédé selon l'une des revendications 1 à 3, **caractérisé en ce que** les adhésifs (4, 5) présentent un recouvrement partiel ou sont disposés à l'interface (11) séparant les couches (12, 15) dans des zones (Z1, Z2,) complémentaires.

5. Procédé selon la revendication 4, **caractérisé en ce que** le second adhésif (5) est de plus grande résistance à la température et/ou à au moins un solvant et se trouve disposé dans des zones (Z2) sensibles situées en regard du module (3) et/ou en regard d'au moins une connexion de l'antenne (2) au module (3).

6. Procédé selon la revendication 4, **caractérisé en ce que** ledit second adhésif (5) est de plus grande résistance à la température et/ou à un solvant que le premier adhésif et se trouve disposé dans une zone centrale (Z2) et **en ce que** premier adhésif (4) est placé autour du second adhésif (5) ou borde le second adhésif (5) sur au moins deux côtés.

7. Procédé selon l'une quelconque des revendications précédentes, **caractérisé en ce qu'**au moins une des deux couches (12, 15) couvre partiellement le circuit transpondeur (2, 3) afin que toute attaque entraîne une rupture du circuit transpondeur (2,3) au croisement du circuit transpondeur avec les deux couches de colle (4, 5).

8. Procédé selon l'une quelconque des revendications précédentes, **caractérisé en ce qu'**au moins un des adhésifs (4, 5) est disposé de manière à présenter dans une direction quelconque à l'interface entre lesdites couches de matériau, au moins une alternance d'adhésifs différents ou ayant des comportements d'adhérence différents selon la température et/ou les solvants.

9. Procédé selon l'une quelconque des revendications précédentes, **caractérisé en ce qu'**au moins un des adhésifs (4, 5) est disposé de manière aléatoire et/ou sous forme de cordon en spirale ou en zigzag ou présente un bord formé de segments de droite brisée ou en forme de denture (17, 18).

10. Document de sécurité obtenu par un procédé selon l'une des revendications 1 à 9, **caractérisé en ce qu'**il se présente sous forme de carte à puce ou de livret (1).
